# EUROPEAN PATENT SPECIFICATION

(11) **EP 0 534 497 B1**
(45) Date of publication and mention of the grant of the patent: **18.02.1998**
(21) Application number: 92119222.5
(22) Date of filing: 25.11.1988
(51) Int. Cl.: H01L 21/322, H01L 21/00

(54) **Semiconductor wafer surface treatment method**
Verfahren zur Oberflächenbehandlung eines Halbleiterplättchens
Méthode de traitement de la surface d'une plaquette semi-conductrice

(30) Priority: 28.11.1987 JP 300356/87
(43) Date of publication of application: 31.03.1993
(62) Divisional of application: 88119716.4
(73) Proprietor: KABUSHIKI KAISHA TOSHIBA, Kawasaki-shi, Kanagawa-ken 210 (JP); Toshiba Micro-Computer Engineering Corporation, Kawasaki-shi (JP)
(72) Inventor: Miyashita, Moriya, c/o Patent Division, Minato-ku, Tokyo 105 (JP); Yoshii, Shintaro, c/o Patent Division, Minato-ku, Tokyo 105 (JP); Sakuma, Keiko, c/o Patent Division, Shinagawa-ku, Tokyo (JP)
(74) Representative: Henkel, Feiler, Hänzel & Partner

(56) References cited:
- WO-A-87/06862
- US-A- 4 326 553
- PATENT ABSTRACTS OF JAPAN vol. 5, no. 121 (E-68)(793) 5 August 1981 & JP-A-56 060 022
- PATENT ABSTRACTS OF JAPAN vol. 10, no. 251 (E-432)(2307) 28 August 1986 & JP-A-61 079 234
- PATENT ABSTRACTS OF JAPAN vol. 12, no. 26 (E-577) 26 January 1988 & JP-A-62 185 322
- PATENT ABSTRACTS OF JAPAN vol. 4, no. 28 (E-1) 8 March 1980 & JP-A-55 001 114

## Description

The present invention relates to a semiconductor wafer surface treatment method and, more particularly, to a method of treating a surface of a semiconductor wafer so that one surface of the wafer may be mechanically damaged for gettering of contaminants.

Along the development of micropatterning of semiconductor elements, it becomes important that influence due to various types of contamination in element manufacturing processes is decreased. For example, contamination with heavy metals such as Cu or Fe reduces life time of minority carriers, thus changing characteristics of a transistor, or increasing a leakage current. In addition, by contamination with sodium (Na), mobile ions are generated in an oxide film, thereby degrading stability of an operation of the elements.

So-called gettering is well-known as such a method of cleaning contamination of a semiconductor substrate generated in a manufacturing process. This gettering includes hydrochloric acid oxidation, phosphorus gettering, and the like which are performed during manufacturing processes. In another technique, a silicon wafer serving as a starting material has a gettering ability. In addition, gettering of a substrate includes intrinsic gettering which utilizes oxygen precipitate in the substrate, back side damage (to be referred to as a BSD hereinafter) which causes the back-side surface of the wafer (an opposite side surface to a major surface on which semiconductor elements are formed in the later steps) to be mechanically damaged or distorted, and the like.

Sandblasting is known as a conventional method of forming the above BSD. In this method, a solution obtained by dispersing fine particles of alumina is sprayed to a back-side surface of the silicon wafer to form a mechanical damage. Although this method is effective to form a mechanical damage, the method cannot provide high purity of the silicon wafer required in the manufacture of the semiconductor element. More specifically, the solution obtained by dispersing fine particles of alumina contains very small amounts of metal impurities such as Fe, Cr, Ni, and Cu. Surface analysis using an ion microanalyzer frequently demonstrated that these impurities are strongly attached to and remain on a wafer material as a surface contamination after the treatment. In addition, the back-side surface of the wafer is a roughened surface, and three-dimensional micropatterns are present therein. However, since a solution containing an alumina is sprayed to this uneven surface, the fine particles of alumina fill the recessed patterns in the back-side surface of the wafer. For this reason, process defects are undesirably caused in manufacturing processes of the semiconductor element, as in the case of surface contamination due to metal impurities.

In a conventional case, treatment processes of the semiconductor wafer are performed in a clean room to manage cleanliness. However, in the sandblasting treatment process, fine particle of alumina solution is sprayed with high pressure. Therefore, the cleanliness in operation environment can be hardly maintained.

As described above, formation of BSD using the conventional sandblasting undesirably has low cleanliness.

Prior art document Patent Abstracts of Japan, vol. 5, no. 121, (E-68) [793], 5 August 1981; & JP-A-5 660 022, discloses a semiconductor wafer processing method in which a wafer is sticked to a wafer supporting disk with the reverse side facing outside, and soaked into an abrasive solution filled in an abrasive solution vessel. Vibrations are given by an ultrasonic vibration generator and a damaged layer is formed with an excellent reproducibility on the reverse side on the wafer. As a uniform back-distortion processed layer is formed hereby, a large quantity of wafers having an increased gettering effect can be manufactured simultaneously.

Further, prior art document Patent Abstracts of Japan, vol. 9, no. 240, (E-245) [1963], 26 September 1985; & JP-A-6 091 648, discloses a semiconductor wafer treatment method in which a semiconductor wafer, whose mirror ground surface has been faced downwards, is containing abrasive particles dipped in water and applied with supersonic oscillation. The wafer is moved vertically to pass through a position, where a standing wave of high energy is generated so as to give mechanical damages. After prescribed damages were given to the wafer, stuck abrasive material is washed off from the wafer. The wafer is then cleaned in a solution of NH₄OH + H₂O₂ + H₂O, and moreover in pure water and made to dry. According to this method, a gettering treatment can be favourably performed on the water by a simple device and the degree of mechanical damages to give to the water can be easily controlled by changing the kind of abrasive material to be used and the abrasive particle diameter, and, by adjusting the supersonic energy applied to the wafer.

Prior art document WO-A-87/06 862 discloses a semiconductor treatment method for cleaning the surface of a semiconductor wafer, wherein an ultrasonic wave is propagated to the surface of the semiconductor wafer via ultrapure water as a treatment solution. The ultrasonic wave has a frequency in the range of 20-100 kHz, and an output power of 400 watts.

Prior art document "Patent Abstracts of Japan", Vol. 10, No. 251 (E-432) [2307], 28^{th} August 1986 (& JP-A-61 079234) discloses a method for forming lattice defects on the back-side surface of a semiconductor substrate wherein high-pressured water is sprayed from a jet nozzle to this back-side surface.

Finally, prior art document US-A 4,326,553 discloses a method wherein a cleaning fluid is sprayed onto one surface of a semiconductor wafer on a rotating table from a nozzle in which an ultrasonic generator is arranged. The nozzle has substantially the same width as the radius of the wafer and is fixed to the cleaning apparatus, and thus, the wafer has to be rotated in order to be sprayed with the ultrapure water vibrated by the ultrasonic wave from the nozzle.

It is an object of the present invention to provide a method of treating a surface of a semiconductor substrate which can form a clean mechanical damage on a back-side surface of the substrate.

To solve this object the present invention provides a method a specified in the claim.

In such a method, the surface (back-side surface) of the semiconductor wafer is irradiated with ultrasonic waves propagating in pure water, so that mechanical damages may be formed on the surface. This damage serves as a back-side damage. In addition, only pure water is brought into contact with the substrate, and impurities such as heavy metals or Na may not be attached to and remain on a wafer material as surface contamination after the treatment, as in the conventional case.

There is, therefore, provided a method of treating a surface of a semiconductor substrate which can form clean mechanical damage on the back-side surface of the wafer.

This invention can be more fully understood from the following detailed description when taken in conjunction with the accompanying drawings, in which
- Fig. 1: is a front view showing an arrangement of the treatment device used when the treatment method of the present invention is performed; and
- Fig. 2: is a view showing a semiconductor wafer during a treatment using a treatment device shown in Fig. 1.

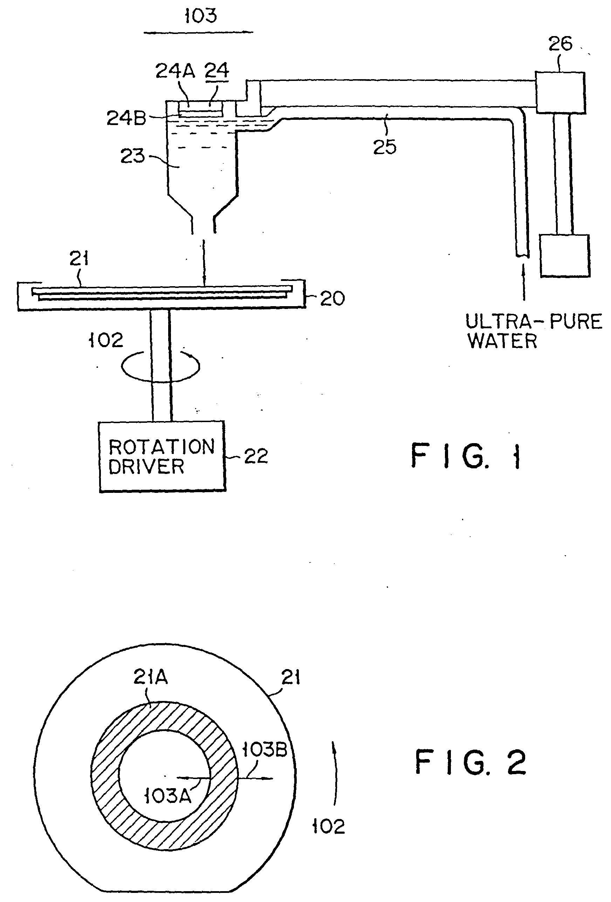

Fig. 1 is a front view showing an arrangement of the treatment device used when a method of the present invention is performed. Wafer table 20 for horizontally holding silicon wafer 21 to be treated is rotated along the direction indicated by arrow 102 in Fig. 1 by rotation driver 22. This table 20 is rotated at, e.g., 100 rpm.

Nozzle 23 is disposed above wafer table 20. Ultrasonic generator 24 consisting of ultrasonic wave oscillator 24A and ultrasonic wave diaphragm 24B is arranged on the inner side of this nozzle 23. Ultrasonic wave diaphragm 24B is disposed to oppose to wafer 21 so that wafer 21 can be easily irradiated with ultrasonic waves through ultrapure water. Supply tube 25 for supplying ultrapure water is connected to a side wall of nozzle 23. Ultrapure water is supplied to the inner space of nozzle 23 through this supply tube 25. Nozzle 23 is movable along the direction indicated by arrow 103 in Fig. 1 by nozzle scan driver 26.

In the treatment device having the above arrangement, silicon wafer 21 is horizontally held by waver table 20 so that the major surface of the wafer faces down and the back-side surface thereof faces up. In addition, ultrapure water is supplied to nozzle 23 from supply tube 25 and ultrasonic waves are generated by ultrasonic generator 24 to perform a treatment. In this case,
an output of the ultrasonic waves is selected within the range of 50 W to 500 W, and its frequency is selected to be 38 kHz.

When ultrapure water is supplied to the inner space of nozzle 23, the ultrapure water oscillated by ultrasonic waves is sprayed from the distal end of nozzle 23 onto the back-side surface of wafer 21 rotated on wafer table 20. Therefore, as shown in Fig. 2, region 21A of wafer 21 indicated by hatched lines in Fig. 2 is sprayed with the ultrapure water, and mechanical damages are formed thereon. Thereafter, while wafer 21 is rotated in the direction indicated by arrow 102 in Fig. 2, nozzle 23 is moved by nozzle scan driver 26 in the direction indicated by arrow 103A or 103B in Fig. 2. Therefore, mechanical damages are sequentially formed on the entire back-side surface of wafer 21.

Even if such a treatment device is used, stacking faults per cm² of about 1 x 10⁵ can be formed on only the back-side surface of silicon wafer 21.

Furthermore, since ultrapure water is used, impurity fine particles and metal contamination attached to the back-side surface can be decreased.

Thus, with the above treating method, ultrasonic waves propagating in ultrapure water are caused to propagate along the back-side surface of the semiconductor wafer, so that mechanical damages are formed. Therefore, cleanliness in this method can be greatly improved as compared to that in formation of mechanical damages by the conventional sandblasting.

## Claims

1. A method for treating the back-side surface of a semiconductor wafer, to form mechanical damages for gettering on said back-side surface, wherein ultrasonic waves are caused to propagate along the back-side surface of said semiconductor wafer (21), through a treatment solution (11), to form the mechanical damages on said back-side surface of said semiconductor wafer (21), wherein:
the step of forming the mechanical damages comprises the substeps of:
placing said semiconductor wafer (21) horizontally on a rotating table (20),
rotating said semiconductor wafer in axis of a center point of said semiconductor wafer (21) by rotating said rotating table (20), and
spraying ultrapure water onto a back-side surface of said semiconductor wafer (21) from a nozzle (23) in which an ultrasonic generator (24) is arranged, said nozzle (23) being moved in a direction along a line from the center point to a periphery of said semiconductor wafer (21), and said ultrasonic generator (24) having an output of the ultrasonic waves selected within the range of 50 W to 500 W, and its frequency being selected to be 38 kHz.

## Patentansprüche

1. Verfahren zur Behandlung der rückseitigen Oberfläche von einem Halbleiterwafer zur Ausbildung mechanischer Schäden auf dieser rückseitigen Oberfläche zum Zwecke der Getterung, bei dem Ultraschallwellen veranlaßt werden, sich entlang der rückseitigen Oberfläche des Halbleiterwafers (21) in einer Behandlungslösung (11) auszubreiten, um die mechanischen Schäden auf der rückseitigen Oberfläche des Halbleiterwafers (21) hervorzurufen, wobei
der Schritt zur Ausbildung der mechanischen Schäden die folgenden Unterschritte enthält:
horizontales Plazieren des Halbleiterwafers (21) auf einem Drehtisch (20),
Drehen des Halbleiterwafers um eine Achse eines Zentralpunkts des Halbleiterwafers (21) durch Drehen des Drehtisches (20), und
Sprühen ultrareinen Wassers auf die rückseitige Oberfläche des Halbleiterwafers (21) aus einer Düse (23), in der ein Ultraschallgenerator (24) angeordnet ist, wobei die Düse (23) in einer Richtung entlang einer Linie vom Zentralpunkt zu einem Umfang bzw. Rand des Halbleiterwafers (21) bewegt wird, und der Ultraschallgenerator (24) eine Ausgangsleistung der Ultraschallwellen ausgewählt innerhalb des Bereichs von 50 W bis 500 W besitzt und seine Frequenz zu 38 kHz gewählt wird.

## Revendications

1. Procédé de traitement de la surface arrière des plaquettes semi-conductrices, pour effectuer des traitements mécaniques pour décontaminer ladite surface arrière, dans laquelle des ondes ultrasonores sont contraintes de se propager sur ladite surface arrière desdites plaquettes semi-conductrices (21), via une solution de traitement (11), pour effectuer des traitements mécaniques de ladite surface arrière desdites plaquettes semi-conductrices (21), dans lequel :
L'étape de formation des défauts mécaniques comprend des sous-étapes de :
placement de ladite plaquette semi-conductrice (21) horizontalement sur la table tournante (20),
rotation de ladite plaquette semi-conductrice selon un axe d'un point central de ladite plaquette semi-conductrice (21) par la rotation de ladite table de rotation (20), et
pulvérisation de l'eau ultra-pure sur une surface arrière de ladite plaquette semi-conductrice (21) à partir d'une buse 23 dans laquelle un générateur ultrasonore (24) est disposé, ladite buse (23) étant déplacée dans une direction le long d'une ligne à partir d'un point central vers le pourtour de ladite plaquette semi-conductrice (21) et ledit générateur ultrasonore (24) ayant une sortie des ondes ultrasonores sélectionnées dans l'intervalle de 50 W à 500 W, et sa fréquence étant sélectionnée pour être de 38 KHz.
